(19) Europäisches Patentamt
European Patent Office
Office européen des brevets

(11) **EP 1 376 974 B1**

(12) **EUROPEAN PATENT SPECIFICATION**

(45) Date of publication and mention
of the grant of the patent:
**08.08.2007 Bulletin 2007/32**

(51) Int Cl.:
*H04L 29/06* (2006.01)

(21) Application number: **02360164.4**

(22) Date of filing: **06.06.2002**

(54) **Method and apparatus for packet header compression**

Verfahren und Vorrichtung zur Paketenkopfkomprimierung

Méthode et appareil pour la compression d'une en-tête de paquet

(84) Designated Contracting States:
**AT BE CH CY DE DK ES FI FR GB GR IE IT LI LU MC NL PT SE TR**

(43) Date of publication of application:
**02.01.2004 Bulletin 2004/01**

(73) Proprietor: **Alcatel Lucent**
**75008 Paris (FR)**

(72) Inventors:
• **Brouet, Jérome**
**75014 Paris (FR)**
• **Antoine, Jacques**
**92320 Chatillon (FR)**
• **Husson, Lionel**
**92190 Meudon (FR)**
• **Wautier, Armelle**
**91190 Gif sur Yvette (FR)**

(74) Representative: **Urlichs, Stefan et al**
**Alcatel Lucent**
**Intellectual Property & Standards**
**70430 Stuttgart (DE)**

(56) References cited:
**US-A1- 2002 038 385**

• **C. BORMANN ET AL: "Request for Comments 3095, Robust header compression (ROHC), framework and four profiles: RTP, UDP, ESP and uncompressed." ., 2001, XP002220600**

**Description**

**BACKGROUND OF THE INVENTION**

The present invention relates to a method for transmitting data packets comprising at least one field containing a compressed value.

IP multimedia packets, or similar data entities comprise usually a long header which should be compressed for transmission on a radio interface for spectrum efficiency purpose. Redundancy between the header of successive packets is used by the compression mechanism to obtain an efficient compression rate. This redundancy extracted from previous transmitted resp. received packets is stored in a context at the transmitter's compression means resp. at the receiver's decompression means. The context should be updated accordingly in order for the mechanism to function error free. Moreover a robust header compression scheme needs mechanisms for avoiding context inconsistencies.

RFC 3095 which is the closest prior art, from IETF discloses a robust header compression. This header compression is possible due to the fact that there is much redundancy between header field values within consecutive data packets. A compression method called Least Significant Bit encoding works as follows: the k least significant bits of a field value are transmitted instead of the original value. After receiving the k bits, the decompressor derives the original value using a previously received value as reference noted v_ref. The scheme is guaranteed to be correct if the compressor and the decompressor each use interpretation intervals in which:

1) the original value resides

2) the original value is the only value that has the exact k least significant bits as those selected for transmission.

The following illustrates a simplified procedure for least significant bit compression and decompression.

1) the compressor resp. decompressor always uses the last value that has been compressed resp. decompressed as reference value v_ref

2) when compressing a value v, the compressor finds the minimum value k such that v falls into the interpretation interval $[v\_ref, v\_ref+2^k-1]$. If several values of k are possible the smallest one this selected

3) when receiving the k least significant bits, the decompressor calculates the interpretation interval as a function of v_ref and k. It picks as decompressed value the one for which the k least significant bits are equal to the received ones.

4) The values to be compressed have a finite range for example from 0 to 0XFFFF. When the value to compress is close to 0XFFFF, the interpretation interval can straddle the wraparound boundary between 0 and 0xFFFF.

In real time data packets, an important field is the time stamp field (TS) which is used for indicating the time of sending of a real time packet. Contrary to a sequence number which is usually incremented by 1, the TS field is incremented for each packet by a multiple of a unit (e.g. TS_STRIDE=160 for 8khz sample rate and 20 ms packet duration). TS is obtained according to the equation:

$$TS=TS\_SCALED*TS\_STRIDE+T\_OFFSET.$$

TS_SCALED being equal to said value to be compressed.
TS_STRIDE being a predefined unit.
TS_OFFSET being an offset between the time scale at the transmitter and at the receiver.

In order to reduce the size of the TS field, only TS/TS_STRIDE is compressed and transmitted to the receiver.. The range of TS/TS_STRIDE is as a consequence 0 to 26843545 if the range for TS is [0, 0xFFFF] (TS usually coded with 32 bits). As a consequence, at wrap around TS/TS_STRIDE jumps from 26843545 to 0.

The header decompression at wraparound presents some difficulties. Indeed, it is possible that the interpretation interval at wraparound comprises more than one single value having as k least significant bits the k received bits.

Example: In the following, the last 10 least significant bits for the values close to the wraparound boundary are listed. In this example, k=5 and v_ref=26843536.

| | |
|---|---|
| 26843536 | ...01 10 01 00 00 (v_ref) |
| 26843537 | ...01 10 01 00 01 |
| 26843538 | ...01 **10 0**1 **00 10** |
| | ... |
| 26843545 | ...01 10 01 10 01 |
| 0 | ...00 00 00 00 00 |
| | ... |
| 18 | ...00 **00 0**1 **00 10** |
| | ... |
| 21 | ...00 00 01 01 01 (v_ref+2$^k$-1). |

Two values 26843538 and 18 mach the received 5 last significant bits 10010. It is impossible for the decompressor to discriminate between the two values.

A solution proposed by RFC 3095 consists in appending at the compressor in case of wraparound a sufficient number, noted b, of "0" to be able to discriminate at the decompressor between several possible values. In the example presented above, three additional bits are necessary to discriminate between 10 01 00 10 (=26843538) and 00 01 00 10 (=18). The transmitted compressed value comprises then k+b bits, b being the number of additional bits required to disambiguate the received value and k being the number of compressed bits when no wraparound happens.

The drawback of this solution is that the compression ratio is not optimal since overhead should be added in case of wraparound.

A particular object of the present invention is to provide a method for compressing a value contained in a data packet where the overhead added in case of wraparound is reduced compared to prior art methods.

Another object of the invention is to provide a transmitter and a receiver both adapted to perform such a method.

## SUMMARY OF THE INVENTION

These objects, and others that appear below, are achieved by a method for transmitting data packets, said data packets comprising a compressed value according to claim 1, a transmitter according to claim 8, and a receiver according to claim 9.

According to the present invention, at transmitter side, when the distance between the value to be compressed and a predefined wrapraound boundary is lower than a predefined threshold value, one additional bit (1 bit) is appended to the compressed value (k bits), said additional bit univocally indicating the relative position of said value to be compressed to said wraparound boundary.

When the transmitted data packet comprising the compressed value (k+1 bits= k bits + additional bit) is received at the receiver, the latter detects that it cannot disambiguate between several values in a first interpretation interval calculated from the k+1 received bits. Then, the receiver recalculates a second interpretation interval with only k received bits. The additional bit is used to discriminate between two possible values of the second interpretation interval in order to have only one matching decompressed value.

The method according to the present invention presents the advantage of providing a higher compression ratio for the compressed field.

A further advantageous feature of the method consists in using this method for compressing the time stamp field of a real time protocol data packet.

Further advantageous features of the invention are defined in the dependent claims.

## BRIEF DESCRIPTION OF THE DRAWINGS

Other characteristics and advantages of the invention will appear on reading the following description of a preferred embodiment given by way of non-limiting illustrations, and from the accompanying drawings, in which:

- Figure 1 shows a system comprising a transmitter and a receiver where the method according to the present invention can be applied;
- Figure 2 shows a flow diagram representing the different steps of the method according to the present invention at a transmitter (fig 2a) and at a receiver (fig 2b).

**DETAILED DESCRIPTION OF THE INVENTION**

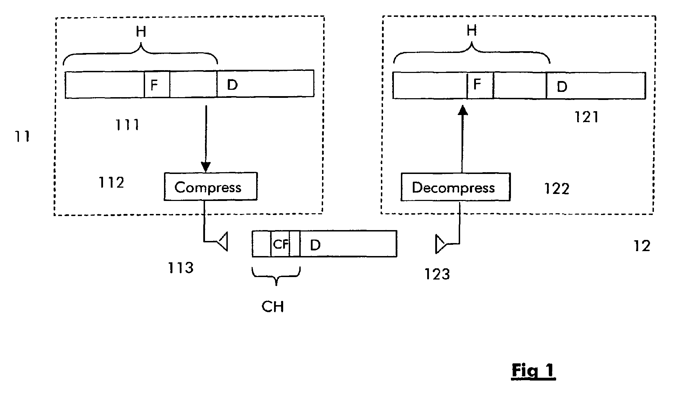

Figure 1 shows a system comprising a transmitter 11 and a receiver 12 where the method according to the present invention can be applied. Transmitter 11 comprises means 111 for generating a data packet comprising a header H and payload data D. Transmitter 11 further comprises a compressor 112 dedicated to compress the data packet header H and an antenna 113 for transmitting the compressed data packet comprising a compressed header CH and payload data D over an air interface to receiver 12.

Receiver 12 comprises an antenna 123 for receiving compressed data packets, a decompressor 122 for decompressing the compressed header CH and means 121 for further processing decompressed data packets.

In a preferred embodiment of the present invention data packets are real time IP datagram according to the real time protocol (RTP) as specified in RFC 1889 from the IETF. It will however be clear for a person skilled in the art that other data packet type may be used without departing from the scope of the present invention (for example RTP/UDP/IP data packets).

Header H comprises preferably several fields (e.g. sequence number, originating and destination address, time stamp for real time protocol and so on...). Compressor 112 preferably compress each field independently of each other. Alternatively, compressor 112 may only compress predefined fields of the header letting uncompressed the fields changing in an unpredictable way.

The compression method according to the present invention may be used for all fields in header H or only for some of them. In a preferred embodiment, the method is only applied to fields for which the variation of the value to be compressed is changing in a limited but not predictable range between two consecutive data packets. One of such field is the time stamp (TS) field for the header used to indicate the time stamp at which the data packet has been generated in real time protocols.

For other fields, either remaining constant or changing in a predeterministic way, usual compression algorithms (e.g. least significant bit compression or window based LBS encoding) may be used. This present the advantage to further optimize the compression ratio since not all types of field necessitate a handling according to the present invention.

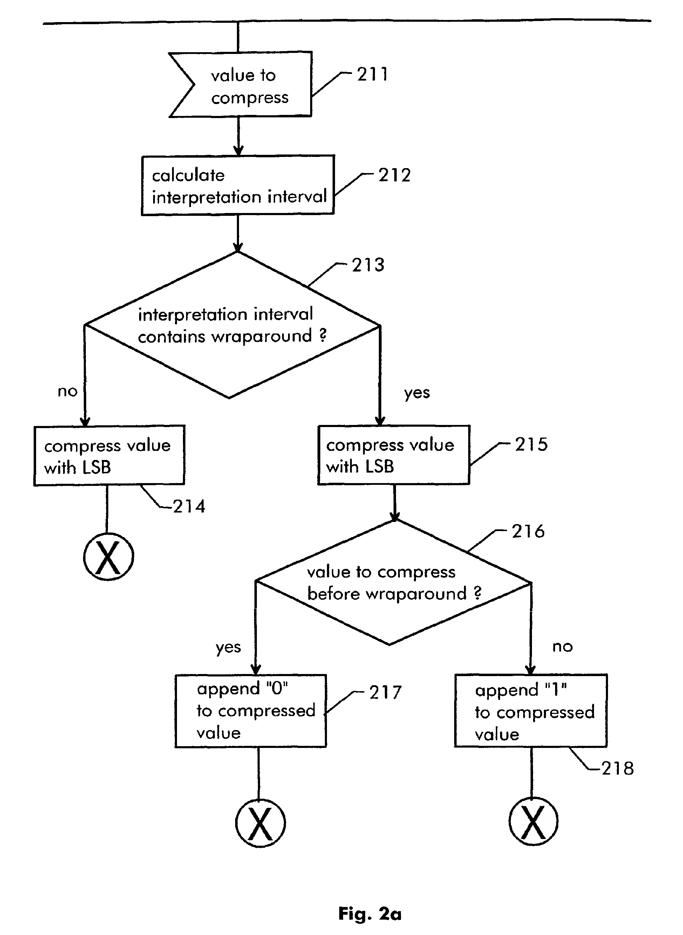

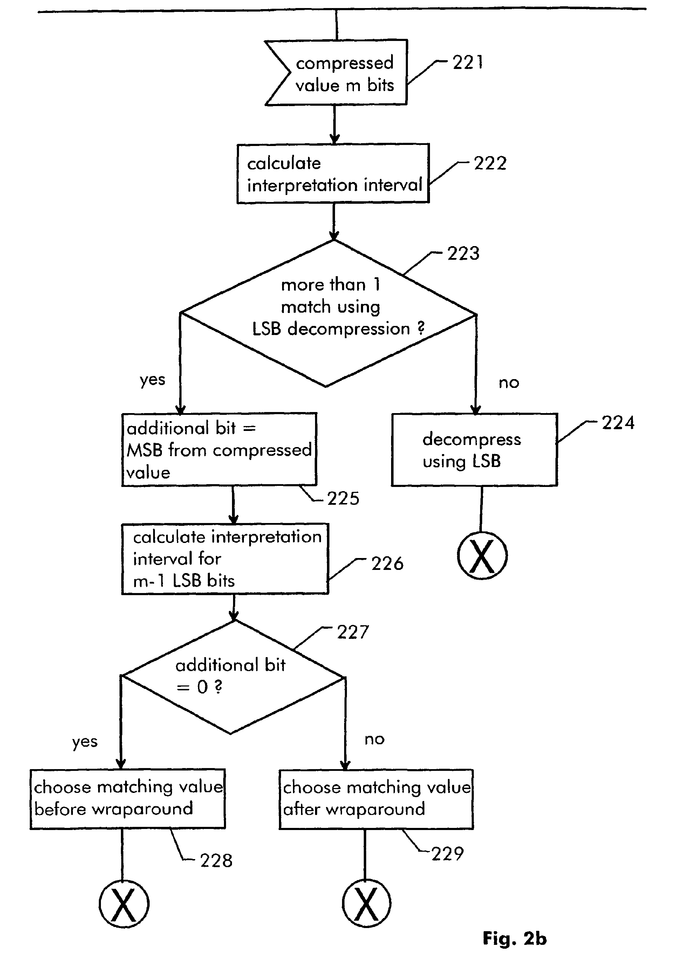

Figure 2 shows a flow diagram representing the different steps of the method according to the present invention at a transmitter (fig 2a) and at a receiver (fig 2b).

At transmitter 11, following steps are performed by compressor 112.

-    At step 211 the compressor 112 receives a value to compress. The compressed value will be stored in a field for compressed header CH.
-    At step 212, the compressor calculates an interpretation interval as if it would compress the value using the Least Significant Bit compression mechanism or one of its variant as presented in RFC 3095.
-    At step 213, the compressor checks if the interpretation interval comprises a wraparound boundary (e.g. wraparound boundary=26853545).
-    If not, the compression is continued using the usual compression algorithm.(step 214)

If a wraparound is detected, step 215 and following are performed:

-    Step 215 consists in generating a compressed value comprising k bits according to the usual compression algorithm. It is to be noted that this compressed value does not univocally represent a value of the interpretation interval because of wraparound. On the contrary, two possible values of the interpretation interval could match the compressed value if using the LBS compression mechanism without modification.
-    Step 216 consists in checking if the value to compress is located before or after the wraparound. If the wraparound happens at value N, values belonging to the interval ]N/2, N[ are deemed to be located before the wraparound while values belonging to interval [0, N/2] are deemed to be located after the wraparound.
-    Step 217 consists in appending to the compressed value an additional bit equal to 0 if the value to compress is located before the wraparound.
-    Step 218 consists in appending to the compressed value an additional bit equal to 1 if the value to compress is located after the wraparound.

Then, if the wraparound happens at a value equals to 26843545, value 18 will be compressed on five bits with 1 00 10. Since 18 is located after the wraparound boundary, a sixth bit equal to 1 will be appended as most significant bit. The compressed value will comprise the six following bits 11 00 10.

It will be clear for a person skilled in the art that the additional bit may be 1 for values located before the wraparound and 0 for values located after. The only requirement is that compressor an decompressor use the same rule for determining the meaning of the additional bit.

In a preferred embodiment of the present invention, the additional bit is appended as most significant bit to the compressed value. However in another embodiment of the present invention the additional bit may be appended as least significant bit of the compressed value.

At receiver 12 following steps are performed by decompressor 122.

- Step 221 consists in receiving at decompressor 122 a compressed value consisting in m bits.
- Step 222 consists in calculating the interpretation interval as a function of m and the reference value stored at the decompressor.
- Step 223 consists in detecting if only one value of the interpretation interval matches the received m bit compressed value.
- If only one value matches, step 224 consists in decompressing the compressed value according to the usual decompression algorithm (e.g. LBS encoding).
- If more than one value matches, steps 225 and following will be executed.
- Step 225 consists in extracting the most significant bit from the m bit compressed value and storing it as additional bit for further processing.
- Step 226 consists in calculating a second interpretation interval as a function of m-1 and the reference value stored at the decompressor.
- Step 227 consists in checking if the additional bit equal 0.
- If additional bit equals 0 step 228 is performed else step 229 is performed.
- Step 228 consists in selecting as decompressed value the only matching value of the second interpretation interval which is located before the wraparound.
- Step 229 consists in selecting as decompressed value the only matching value which is located after the wraparound.

The present invention also addresses a transmitter comprising means for performing steps 211 to 217 described in figure 2a as well as a receiver comprising means for performing steps 221 to 229 described in figure 2b.

The method according to the present invention leads to higher compression ratio as shown in the example detailed in "prior art" section and in "detailed description of the invention" section. Assuming wraparound boundary=26843545, assuming synchronous compressor and decompressor with v_ref=26843536, considering that the value to compress is v=18, then the compressor evaluates the interpretation interval {26843536 ... ... 26843545 0 1 ...10 ... 21 }. It follows that for prior art solution according to RFC 3095 rule, the compressed value is 00010010 (8 bits). According to the present invention, the value is compressed to 010010 (6 bits).

Another example obtained for a wraparound boundary equal to 26738713=1 10 01 10 00 00 00 00 00 00 01 10 01, v_ref=26738711, and the value to compress v=10, leads to value compressed on 20 bits for RFC 3095 usual compression algorithm and 6 bits for the compression method according to the present invention.

The advantage in term of compression ratio is higher when the value TS_STRIDE is higher.

**Claims**

1.  Method for transmitting data packets, said data packets comprising a field (CF) containing a compressed value, said compressed value representing a value evolving between two consecutive data packets and being comprised in a predefined interval, herein called interpretation interval, said method **characterized by** comprising the steps of:

    - if the distance between said value to be compressed and a predefined wraparound boundary is lower than a predefined threshold value, appending an additional bit to said compressed value, said additional bit univocally indicating the relative position of said value to be compressed to said wraparound boundary.
    - at a receiver (12), computing a first interpretation interval in accordance with all received bits of said compressed value;
    - signalling a wraparound if more than one value of said first interpretation interval matches the received compressed value;
    - upon signalling of a wraparound, computing a second interpretation interval in accordance with all received bits of said compressed value except said additional bit;
    - disambiguating the decompressed value in said second interpretation interval using said additional bit.

2.  Method according to claim 1, wherein the variation of said value to be compressed between two successive data packets is changing in a limited range.

3.  Method according to claim 2, wherein said value to be compressed represents the timestamp (TS) value used in real time communication protocols.

4. Method according to claim 3, wherein said timestamp value is obtained by

$$TS=TS\_SCALED*TS\_STRIDE+T\_OFFSET.$$

TS=TS_SCALED*TS_STRIDE+T_OFFSET.
TS_SCALED being equal to said value to be compressed.
TS-STRIDE being a predefined unit.
TS_OFFSET being an offset between the time scale at the transmitter and at the receiver.

5. Method according to claim 1, wherein said compressor calculates a reference value depending on values to be compressed in at least one previous data packet, said first and second interpretation interval depending on said reference value and on the number of bits of said compressed value.

6. Method according to claim 1, wherein said additional bit is appended as most significant bit to said compressed value.

7. Method according to claim 1, used on a radio link of a wireless communication network.

8. Transmitter (11) for transmitting data packets, preferably on a radio link, to a receiver, said data packets comprising a field (CF) containing a compressed value, said compressed value representing a value evolving between two consecutive data packets and being comprised in a predefined interval, herein called interpretation interval, said transmitter comprising compressing means(112) for said value , said compressing means (112) **characterized by** comprising:

   - means for detecting if the distance between said value to be compressed and a predefined wraparound boundary is lower than a predefined threshold value;
   - means for appending an additional bit to said encoded value, said additional bit univocally indicating the relative position of said value to be compressed to said wraparound boundary.

9. Receiver (12) for receiving data packets, preferably from a radio link, said data packets comprising a field (CF) containing a compressed value, said compressed value representing a value evolving between two consecutive data packets and comprised in an interval of interpretation, said receiver (12) comprising means (122) for decompressing said compressed value, said decompressing means (122) **characterized by** comprising:

   - means for computing a first interpretation interval in accordance with all received bits of said compressed value;
   - means for signalling a wraparound if more than one value of said first interpretation interval matches said compressed field;
   - means for computing a second interpretation interval in accordance with all received bits of said compressed value except one predefined bit;
   - means for disambiguating the decompressed value in said second interpretation interval using said predefined bit.

**Patentansprüche**

1. Verfahren zum Senden von Datenpaketen, wobei die Datenpakete ein Feld (CF) enthalten, das einen komprimierten Wert enthält, wobei der komprimierte Wert einen Wert darstellt, der zwischen zwei aufeinander folgenden Datenpaketen entsteht und in einem vorher festgelegten Intervall enthalten ist, das hier Interpretations-Intervall genannt wird, wobei das Verfahren **dadurch gekennzeichnet ist, dass** es folgende Schritte umfasst:

   - Wenn der Abstand zwischen dem zu komprimierenden wert und einer vordefinierten Überlauf-Grenze kleiner als ein vordefinierter Schwellwert ist, wird ein zusätzliches Bit an den komprimierten Wert angehängt, wobei das zusätzliche Bit eindeutig die relative Position des zu komprimierenden Wertes zur Überlauf-Grenze anzeigt.
   - An einem Empfänger (12) Berechnung eines ersten Interpretations-Intervalls entsprechend allen empfangenen Bits des komprimierten Wertes;
   - Signalisierung eines Überlaufs, wenn mehr als ein Wert des ersten Interpretations-Intervalls mit dem empfangenen komprimierten Wert übereinstimmt;

- Bei Signalisierung eines Überlaufs Berechnung eines zweiten mterpretations-mtervalls entsprechend allen empfangenen Bits des komprimierten Wertes mit Ausnahme des zusätzlichen Bits;
- Eindeutige Festlegung des dekomprimierten Wertes im zweiten mterpretations-mtervall unter Verwendung des zusätzlichen Bits.

2. Verfahren gemäß Anspruch 1, wobei die Änderung des zu komprimierenden Wertes zwischen zwei aufeinander folgenden Datenpaketen sich in einem begrenzten Bereich ändert.

3. Verfahren gemäß Anspruch 2, wobei der zu komprimierende Wert den Wert des Zeitstempels (TS) darstellt, der in Echtzeit-Kommunikations-Protokollen benutzt wird.

4. Verfahren gemäß Anspruch 3, wobei der Wert des Zeitstempels wie folgt erhalten wird

$$TS = TS\_SCALED*TS\_STRIDE+T\_OFFSET.$$

TS_SCALED ist der zu komprimierende Wert.
TS_STRIDE ist eine vorher festgelegte Einheit.
T_OFFSET ist ein Versatz zwischen dem Zeitmaßstab am Sender und am Empfänger.

5. Verfahren gemäß Anspruch 1, wobei der Komprimierer einen Referenzwert berechnet, der von den zu komprimierenden Werten in mindestens einem vorherigen Datenpaket abhängt, wobei das erste und das zweite Interpretations-Intervall von dem Referenzwert und der Anzahl von Bits des komprimierten Wertes abhängt.

6. Verfahren gemäß Anspruch 1, wobei das oben erwähnte Bit als höchstwertiges Bit an den komprimierten Wert angehängt wird.

7. Verfahren gemäß Anspruch 1, das auf einer Funkverbindung eines drahtlosen Kommunikationsnetzes benutzt wird.

8. Sender (11) zum Senden von Datenpaketen, vorzugsweise auf einer Funkverbindung, zu einem Empfänger, wobei die Datenpakete ein Feld (CF) enthalten, das einen komprimierten Wert enthält, wobei der komprimierte Wert einen Wert darstellt, der zwischen zwei aufeinander folgenden Datenpaketen entsteht und in einem vorher festgelegten Intervall enthalten ist, das hier Interpretations-Intervall genannt wird, wobei der Sender Komprimierungs-Mittel (112) für den Wert enthält, wobei die Komprimierungs-Mittel **dadurch gekennzeichnet sind, dass** sie folgendes enthalten:

- Mittel um zu erkennen, ob der Abstand zwischen dem zu komprimierenden Wert und einer vordefinierten Überlauf-Grenze kleiner als ein vordefinierter Schwellwert ist;
- Mittel zum Anhängen eines zusätzlichen Bits an den codierten Wert, wobei das zusätzliche Bit eindeutig die relative Position des zu komprimierenden Wertes zur Überlauf-Grenze anzeigt.

9. Empfänger (12) zum Empfangen von Datenpaketen, vorzugsweise von einer Funkverbindung, wobei die Datenpakete ein Feld (CF) enthalten, das einen komprimierten Wert enthält, wobei der komprimierte Wert einen Wert darstellt, der zwischen zwei aufeinander folgenden Datenpaketen entsteht und in einem Interpretations-Intervall enthalten ist, wobei der Empfänger (12) Mittel (122) zum Dekomprimieren des komprimierten Wertes enthält, wobei die Dekomprimierungs-Mittel (122) **dadurch gekennzeichnet sind, dass** sie folgendes enthalten:

- Mittel zur Berechnung eines ersten Interpretations-Intervalls entsprechend allen empfangenen Bits des komprimierten Wertes;
- Mittel zur Signalisierung eines Überlaufs, wenn mehr als ein Wert des ersten Interpretations-Intervalls mit dem empfangenen komprimierten Wert übereinstimmt;
- Mittel zur Berechnung eines zweiten Interpretations-Intervalls entsprechend allen empfangenen Bits des komprimierten Wertes mit Ausnahme eines vorher festgelegten Bits;
- Mittel zur eindeutigen Festlegung des dekomprimierten Wertes im zweiten Interpretations-Intervall unter Verwendung des vorher festgelegten Bits.

**Revendications**

1. Procédé de transmission de paquets de données, lesdits paquets de données comprenant un champ (CF) contenant une valeur comprimée, ladite valeur comprimée représentant une valeur émise entre deux paquets de données consécutifs et étant comprise dans un intervalle prédéfini, appelé ici intervalle d'interprétation, ledit procédé étant **caractérisé en ce qu'**il comprend les étapes suivantes :

   si la distance entre ladite valeur à comprimer et une limite de chevauchement prédéfinie est inférieure à une valeur de seuil prédéfinie, ajout d'un bit supplémentaire à ladite valeur comprimée, ledit bit supplémentaire indiquant de façon univoque la position relative de ladite valeur à comprimer par rapport à ladite limite de chevauchement ;
   au niveau d'un récepteur (12), calcul d'un premier intervalle d'interprétation en fonction de tous les bits reçus de ladite valeur comprimée ;
   signalement d'un chevauchement si plusieurs valeurs dudit intervalle d'interprétation correspondent à la valeur comprimée reçue ;
   suite au signalement d'un chevauchement, calcul d'un second intervalle d'interprétation en fonction de tous les bits reçus de ladite valeur comprimée à l'exception dudit bit supplémentaire ;
   résolution de ambiguïté de la valeur décomprimée dans ledit second intervalle d'interprétation en utilisant ledit bit supplémentaire.

2. Procédé selon la revendication 1, dans lequel la variation de ladite valeur à comprimer entre deux paquets de données successifs change dans une plage limitée.

3. Procédé selon la revendication 2, dans lequel ladite valeur à comprimer représente la valeur d'horodatage (TS) utilisée dans les protocoles de communication en temps réel.

4. Procédé selon la revendication 3, dans lequel ladite valeur d'horodatage est obtenue par

$$TS = TS\_CORRÉLÉ * CADENCE\_TS + DÉCALAGE\_TS$$

   TS_CORRÉLÉ étant égal à ladite valeur à comprimer,
   CADENCE_TS étant une unité prédéfinie,
   DÉCALAGE_TS étant un décalage entre l'échelle de temps au niveau de l'émetteur et du récepteur.

5. Procédé selon la revendication 1, dans lequel ledit compresseur calcule une valeur de référence en fonction des valeurs à comprimer dans au moins un paquet de données précédent, lesdits premier et second intervalles d'interprétation dépendant de ladite valeur de référence et du nombre de bits de ladite valeur comprimée.

6. Procédé selon la revendication 1, dans lequel ledit bit supplémentaire est joint comme bit de poids fort (MSB) à ladite valeur comprimée.

7. Procédé selon la revendication 1, utilisé sur une liaison radio d'un réseau de communication sans fil.

8. Émetteur (11) destiné à émettre des paquets de données, de préférence sur une liaison radio, à un récepteur, lesdits paquets de données comprenant un champ (CF) contenant une valeur comprimée, ladite valeur comprimée représentant une valeur émise entre deux paquets de données consécutifs et étant comprise dans un intervalle prédéfini appelé ici intervalle d'interprétation, ledit émetteur comprenant des moyens de compression (112) pour ladite valeur, lesdits moyens de compression (112) étant **caractérisés en ce qu'**ils comprennent :

   des moyens destinés à détecter si la distance entre ladite valeur à comprimer et une limite de chevauchement prédéfinie est inférieure à une valeur de seuil prédéfinie ;
   des moyens destinés à joindre un bit supplémentaire à ladite valeur codée, ledit bit supplémentaire indiquant de façon univoque la position relative de ladite valeur à comprimer par rapport à ladite limite de chevauchement.

9. Récepteur (12) destiné à recevoir des paquets de données, de préférence sur une liaison radio, lesdits paquets de données comprenant un champ (CF) contenant une valeur comprimée, ladite valeur comprimée représentant une valeur émise entre deux paquets de données consécutifs et étant comprise dans un intervalle d'interprétation, ledit récepteur (12) comprenant des moyens (122) destinés à décomprimer ladite valeur comprimée, lesdits moyens de décompression (122) étant **caractérisés en ce qu'**ils comprennent :

des moyens destinés à calculer un premier intervalle d'interprétation en fonction de tous les bits reçus de ladite valeur comprimée ;

des moyens destinés à signaler un chevauchement si plusieurs valeurs dudit premier intervalle d'interprétation correspondent audit champ comprimé ;

des moyens destinés à calculer un second intervalle d'interprétation en fonction de tous les bits reçus de ladite valeur comprimée à l'exception d'un bit prédéfini ;

des moyens destinés à lever l'ambiguïté de la valeur décomprimée dans ledit second intervalle d'interprétation en utilisant ledit bit prédéfini.

**Fig 1**

```
                    ┌─────────────┐
                   /  value to     \  ─── 211
                   \  compress     /
                    └─────┬───────┘
                          │
                          ▼
                  ┌────────────────┐
                  │ calculate      │ ── 212
                  │ interpretation │
                  │ interval       │
                  └───────┬────────┘
                          │
                          ▼
                     ╱─────────────╲  ── 213
                    ╱ interpretation ╲
                   ╱  interval        ╲
                   ╲  contains         ╱
                    ╲ wraparound ?    ╱
                     ╲───────────────╱
              no  ╱                  ╲  yes
                 ▼                    ▼
        ┌────────────────┐    ┌────────────────┐
        │ compress value │    │ compress value │ ── 215
        │ with LSB       │    │ with LSB       │
        └────────┬───────┘    └───────┬────────┘
             214 │                    │
                 ▼                    ▼
                (X)                ╱────────╲  ── 216
                                  ╱ value to  ╲
                                 ╱ compress    ╲
                                 ╲ before       ╱
                                  ╲ wraparound ?╱
                                   ╲──────────╱
                           yes  ╱              ╲  no
                               ▼                ▼
                     ┌──────────────┐  ┌──────────────┐
                     │ append "0"   │  │ append "1"   │
                     │ to compressed│  │ to compressed│
                     │ value        │  │ value        │
                     └──────┬───────┘  └──────┬───────┘
                        217 │              218 │
                            ▼                  ▼
                           (X)                (X)
```

**Fig. 2a**

**Fig. 2b**